# EUROPEAN PATENT APPLICATION

(11) **EP 4 788 087 A1**
(43) Date of publication of application: **05.08.2026**
(21) Application number: 25813729.8
(22) Date of filing: 12.06.2025
(51) Int. Cl.: H10D 30/60, H10D 64/01, H10D 64/27, H10D 62/10

(54) **SHIELDED GATE TRENCH DEVICE AND MANUFACTURING METHOD THEREFOR**

(30) Priority: 09.12.2024 CN 202411804877
(71) Applicant: Hangzhou Fullsemi Semiconductor Co., Ltd., Hangzhou, Zhejiang 311418 (CN)
(72) Inventor: LAN, Zongjin, Hangzhou, Zhejiang 311418 (CN); CHEN, Guoshuai, Hangzhou, Zhejiang 311418 (CN); LI, Xiuzhu, Hangzhou, Zhejiang 311418 (CN); LI, Yu, Hangzhou, Zhejiang 311418 (CN)
(74) Representative: Canzler & Bergmeier Patentanwälte Partnerschaft mbB
(86) International application number: PCT/CN2025/100629
(87) International publication number: WO 2026/123625

(57) **Abstract**

A shielded-gate-trench device and method for preparing the same. The method includes: providing a substrate, the substrate including an epitaxial layer, a first trench within the epitaxial layer, and a first oxide layer covering an inner wall of the first trench and partially covering the epitaxial layer; forming a polysilicon structure filling the first trench, a doping concentration of the polysilicon structure decreasing progressively from a bottom to a top of the first trench; etching back the polysilicon structure to form a second trench, wherein a polysilicon trench wall of the second trench overlaps the first oxide layer on the inner wall of the first trench, the second trench is used to form a shielded gate structure; and forming a second oxide layer on the polysilicon trench wall through oxidation, a thickness of the second oxide layer decreasing progressively from the bottom to the top of the first trench.

## Description

### FIELD OF THE INVENTION

The present disclosure generally relates to semiconductor technology, in particular, to a shielded-gate-trench device and a method for preparing the same.

### BACKGROUND OF THE INVENTION

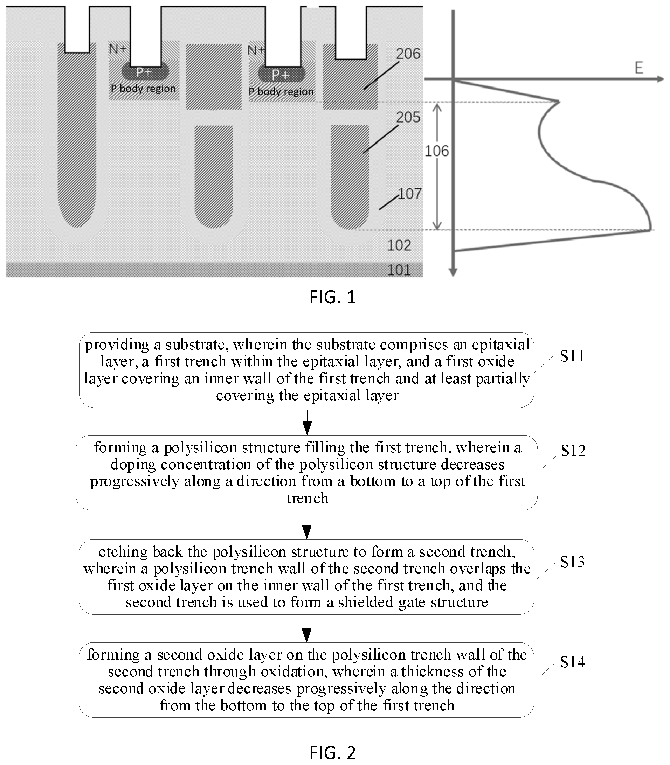

A shielded-gate device is a semiconductor device featuring a shield gate within its body region, such as a shielded-gate-trench (SGT) MOSFET. The shield gate can introduce a lateral electric field in the body region to assist in depleting the drift region. However, the lateral electric field along the trench depth exhibits a nonuniform distribution characterized by low strength in the central portion and high strength at the bottom (refer to FIG. 1), resulting in suboptimal and unstable device breakdown voltage. Conventional techniques to address this issue involve using an epitaxial layer with a graded doping concentration or employing a composite material layer as a field oxide on the trench inner wall. The latter utilizes differential etch rates to form a stepped field plate, thereby enhancing the central field strength and mitigating the issue of its weakness. However, the former method provides limited improvement in field distribution and adversely affects the etching of the shielded gate trench, leading to issues like uncontrollable trench dimensions. The latter method is only suitable for high-voltage devices requiring thick field plates and cannot be adapted to medium/low-voltage devices which require thinner field oxides.

### SUMMARY OF THE INVENTION

To address the aforementioned technical issues, one aspect of the present disclosure provides a method for preparing a shielded-gate-trench device. The method includes:
providing a substrate, wherein the substrate includes an epitaxial layer, a first trench within the epitaxial layer, and a first oxide layer covering an inner wall of the first trench and at least partially covering the epitaxial layer;
forming a polysilicon structure filling the first trench, wherein a doping concentration of the polysilicon structure decreases progressively along a direction from a bottom to a top of the first trench;
etching back the polysilicon structure to form a second trench, wherein a polysilicon trench wall of the second trench overlaps the first oxide layer on the inner wall of the first trench, and the second trench is used to form a shielded gate structure; and
forming a second oxide layer on the polysilicon trench wall of the second trench through oxidation, wherein a thickness of the second oxide layer decreases progressively along the direction from the bottom to the top of the first trench.

In an exemplary embodiment, along the direction from the bottom to the top of the first trench, the doping concentration of the polysilicon structure decreases in a stepped manner, and the thickness of the second oxide layer decreases in a stepped manner; or
along the direction from the bottom to the top of the first trench, the doping concentration of the polysilicon structure gradually decreases, and the thickness of the second oxide layer gradually decreases.

In an exemplary embodiment, the polysilicon structure includes multiple polysilicon layers stacked along a depth direction of the first trench, and doping concentrations of the multiple polysilicon layers exhibit a progressive gradation; wherein forming the polysilicon structure filling the first trench includes:
repeatedly performing a process sequence of doped polysilicon deposition and polysilicon etch-back to form the multiple polysilicon layers, wherein a gas flow rate of dopant elements is progressively decreased with each deposition.

In an exemplary embodiment, a doping concentration and thickness of each of the multiple polysilicon layers are determined based on simulated structural design data corresponding to the shielded-gate-trench device ,wherein the simulated structural design data is generated based on a pre-defined electric field distribution in a body region of the shielded-gate-trench device, wherein the pre-defined electric field distribution is used to indicate a desired strength distribution of a lateral electric field in the body region along the depth direction of the first trench.

In an exemplary embodiment, the oxidation of the polysilicon trench wall of the second trench is performed by a wet oxygen thermal oxidation process.

In an exemplary embodiment, providing the substrate includes:
providing an initial substrate, wherein the initial substrate includes a substrate layer and an epitaxial layer on one side of the substrate layer;
etching the epitaxial layer to form the first trench; and
forming the first oxide layer by depositing an oxide film, wherein the first oxide layer conformally covers at least a part of the epitaxial layer and the inner wall of the first trench.

In an exemplary embodiment, etching back the polysilicon structure to form the second trench includes:
grinding the polysilicon structure until the first oxide layer on top surfaces of the epitaxial layer is exposed;
forming a mask layer on the first oxide layer and the polysilicon structure to mask the first oxide layer and a first portion of the polysilicon structure configured to be a sidewall of the polysilicon trench wall of the second trench, while exposing a second portion of the polysilicon structure that defines the second trench;
dry etching the substrate with the mask layer to form the second trench, and removing the mask layer.

In an exemplary embodiment, process parameters for the dry etching are determined based on a preset etch angle corresponding to simulation structural design data and a preset thickness of a bottom wall of the polysilicon trench wall of the second trench, wherein the preset etch angle is inversely correlated with a thickness gradient of the second oxide layer, wherein the preset etch angle is defined as an acute angle between a sidewall of the second trench and a top surface of the substrate, and is the complement of an acute angle between the sidewall of the second trench and a bottom wall of the second trench.

In an exemplary embodiment, after forming the second oxide layer on the polysilicon trench wall of the second trench through oxidation, the method further includes:
forming the shielded gate structure in the second trench, wherein the shielded gate structure conforms to a shape of the second oxide layer, wherein along a direction from a bottom to a top of the second trench, a width of the shielded gate structure increases progressively.

Another aspect of the present disclosure provides a shielded-gate-trench device, wherein the shielded-gate-trench device is prepared based on the method described above.

In an exemplary embodiment, the shielded-gate-trench device includes:
a substrate, including an epitaxial layer and a first trench located in the epitaxial layer;
a first oxide layer covering an inner wall of the first trench and at least partially covering the epitaxial layer; and
a field oxide layer disposed on the inner wall of the first trench, wherein the field oxide layer encloses to form a second trench, and a thickness of the field oxide layer decreases progressively along a direction from a bottom to a top of the first trench.

In an exemplary embodiment, along the direction from the bottom to the top of the first trench, the thickness of the field oxide layer decreases in a stepped manner; alternatively, along the direction from the bottom to the top of the first trench, the thickness of the field oxide layer decreases in a gradual manner.

Another aspect of the present disclosure provides an integrated circuit including the shielded-gate-trench device.

Another aspect of the present disclosure provides an electronic device including the shielded-gate-trench device.

Based on the above technical solution, the present disclosure offers the following beneficial effects:
In the present disclosure, a filled polysilicon structure is formed in the first trench of the epitaxial layer. Along the direction from the bottom to the top of the first trench, the doping concentration of the polysilicon structure decreases progressively, forming a pre-structure for field oxide formation. Subsequently, the polysilicon structure undergoes an etch-back process to form a second trench, thereby obtaining a trench wall with a concentration gradient. Further, an oxidation process is performed to oxidize the polysilicon trench wall, resulting in the formation of a second oxide layer. Due to the variation in doping concentration, the thickness of the second oxide layer also changes accordingly. The second oxide layer then combines with the first oxide layer to form a field oxide layer whose thickness changes progressively from the bottom to the top of the first trench. This enables free regulation of the width of the shielded gate structure in the second trench, significantly addressing the issue of low electric field strength in the middle of the body region. As a result, the integral area of the electric field in the body region tends to be maximized, effectively improving the breakdown voltage performance of the device. Furthermore, during the preparation of the second oxide layer, only a single thermal oxidation process is required. This results in a low thermal budget and prevents the reverse diffusion of doped impurities in the substrate, thereby avoiding a reduction in the device's breakdown voltage performance. In addition, by modulating the doping concentration of the polysilicon structure within the trench, free regulation of the thickness dimension and thickness variation of the field oxide layer can be achieved. This approach does not impose restrictions on the thickness of the field oxide layer, offering a high degree of freedom in structure preparation and enabling adaptation to voltage-resistant devices with various voltage requirements.

### BRIEF DESCRIPTION OF DRAWINGS

In order to more clearly illustrate the technical solutions in embodiments of the present disclosure, the following is a brief description of the accompanying drawings to be used in the description of the embodiments, it is obvious that the following description of the accompanying drawings are only some embodiments of the present disclosure, for a person of ordinary skill in the art, without creative work, other drawings can be obtained according to these accompanying drawings.
FIG. 1 is a schematic structural diagram of a shielded-gate-trench device in related technologies;
FIG. 2 is a flowchart of an exemplary method for preparing a shielded-gate-trench device according to an embodiment of the present disclosure;
FIGs. 3-11 are schematic cross-sectional diagrams of intermediate structures obtained during preparation of an exemplary shielded-gate-trench device according to an embodiment of the present disclosure;
FIG. 12 is a schematic cross-sectional diagram of a reference shielded-gate-trench device according to an embodiment of the present disclosure; and
FIG. 13 is a lateral electric field distribution diagram of a device body region of an exemplary shielded-gate-trench device according to an embodiment of the present disclosure.

The following is an additional description of the reference numerals in the drawings:
101 - Substrate layer, 102 - Epitaxial layer, 103 - First oxide layer, 104 - Second oxide layer, 105 - First trench, 106 - Body region, 107 - Field oxide layer, 201 - Polysilicon structure, 202 - Polysilicon layer, 203 - Polysilicon trench wall, 204 - Second trench, 205 - Shielded gate structure, 206 - Gate structure, 207 - Isolation oxide layer, 301 - Mask layer.

### DETAILED DESCRIPTION

Below, the technical solutions in the embodiments of the present disclosure will be described clearly and completely with reference to the accompanying drawings in the embodiments of the present disclosure. The described embodiments are a part of the embodiments of the present disclosure, rather than all the embodiments thereof. All other embodiments obtained by a person skilled in the art based on the embodiments in the present disclosure without creative work shall fall within the scope of the present disclosure.

The term "one embodiment" or "an embodiment" as used herein refers to a specific feature, structure, or characteristic that can be included in at least one implementation manner of the present disclosure. It should be understood that terms such as "top," "bottom," "up," "down," as used herein indicate orientations or positional relationships based on the orientations or positional relationships shown in the drawings. These terms are used solely for ease of description of the application and for simplified description, and are not intended to indicate or imply that the referenced device must have a specific orientation, be constructed and operated with a specific orientation, and therefore should not be understood as a limitation on the present disclosure. In addition, the terms like "first" and "second" are used for descriptive purpose only, and are not to be construed as indicating or implying relative importance or implicitly specifying numbers of technical features indicated. Thus, features qualified with terms like "first" and "second" may explicitly or implicitly include one or more such features. Moreover, the terms "first", "second", and the like are used to distinguish similar objects, and are not necessarily used to describe a specific order or sequence. It should be understood that numbers used in this way can be interchanged under appropriate circumstances, so that the embodiments of the present disclosure described herein can be implemented in an order other than those illustrated or described herein.

When a numerical range is disclosed herein, the aforesaid range is deemed continuous and includes the minimum and maximum values of the range, as well as every value between such minimum and maximum values. Further, when the range refers to integers, it includes every integer between the minimum and maximum values of the range. In addition, when multiple ranges are provided to describe a feature or characteristic, such ranges may be combined. In other words, unless otherwise specified, all ranges disclosed herein shall be understood to include any and all subranges subsumed therein. For example, the range from "1 to 10" shall be deemed to include any and all subranges between the minimum value of 1 and the maximum value of 10. Exemplary subranges of the range 1 to 10 include, but are not limited to, 1 to 6.1, 3.5 to 7.8, 5.5 to 10, etc.

The term "layer" as used in the present disclosure refers to a portion of material that includes a region with a certain thickness. A layer may extend over the entire underlying or overlying structure, or may extend over a local area of the underlying or overlying structure. In addition, a layer may be a region of a homogeneous or heterogeneous continuous structure, with a thickness smaller than that of the continuous structure. For example, a layer may be located between the top and bottom surfaces of a continuous structure, or between any pair of horizontal planes therein. A layer may extend horizontally, vertically, and/or along a tapered surface. One layer may include multiple sublayers. For example, the field oxide layer 107 may include the first oxide layer 103, the second oxide layer 104, etc., which may be composed of the same or different materials.

It should be understood that the terms such as "consistent" and "perpendicular" used in the present disclosure refer to substantially consistent or substantially perpendicular within the allowable process tolerance, and do not denote absolute consistency or absolute perpendicularity in a physical sense.

It should be understood that the term "plane" used in the present disclosure, such as "first plane" and "second plane", refers to the XY plane of the substrate or the like, corresponding to the XY plane of the semiconductor device. The "in-plane direction" refers to the direction parallel to the XY plane, and the "thickness direction", "trench depth direction" or "longitudinal direction" refers to the Z direction relative to the XY plane.

Below, a method for preparing a shielded-gate-trench device according to embodiments of the present disclosure is described with reference to FIGs. 2-12, where FIG. 2 is a flow chart of the method for preparing the shielded-gate-trench device. This specification provides method operation steps such as those in the embodiments or flowcharts; however, based on conventional or non-inventive labor, more or fewer operation steps may be included. The sequence of steps listed in the embodiments is merely one of numerous possible execution orders and does not represent the only execution order. In the actual implementation of the method, the steps may be executed in the order shown in the embodiments or the accompanying drawings, or in parallel. The method includes steps S11-S14.

S11: providing a substrate.

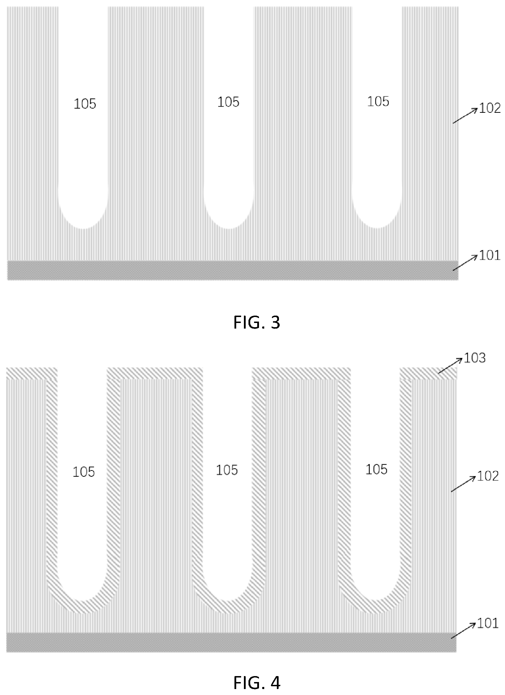

Specifically, referring to FIG. 4, the substrate includes an epitaxial layer 102, a first trench 105 located in the epitaxial layer 102, and a first oxide layer 103 covering at least part of the epitaxial layer 102 and the inner wall of the first trench 105.

Specifically, the substrate further includes a substrate layer 101, and the epitaxial layer 102 is formed on one side of the substrate layer 101. The substrate layer 101 is a semiconductor base capable of semiconductor device processing. Exemplarily, the constituent material of the substrate layer 101 may be at least one of silicon, silicon-containing materials (such as III-V compound semiconductor materials like gallium arsenide (GaAs)), silicon on insulator (SOI), and any other types of semiconductor materials capable of forming the substrate layer 101.

Specifically, the epitaxial layer 102 is formed on the substrate layer 101. Optionally, the epitaxial layer 102 may be specifically formed by an epitaxial growth process. It may be a homoepitaxial layer 102 of the substrate layer 101 (e.g., an epitaxial layer 102 that can continue to grow along the lattice direction of the substrate layer 101) or a heteroepitaxial layer 102. The specific process conditions such as growth temperature may be the same as those of existing processes or may be adaptively adjusted. Optionally, the epitaxial layer 102 may be formed by Chemical Vapor Deposition (CVD), Physical Vapor Deposition (PVD), Atomic Layer Deposition (ALD), or other methods. Exemplarily, the material of the epitaxial layer 102 may include silicon, germanium, gallium arsenide (GaAs), gallium phosphide (GaP), gallium nitride (GaN), etc., or other materials that can be epitaxially grown or deposited on the substrate layer 101 and are suitable for device region processing.

Specifically, the first trench 105 is formed in the epitaxial layer 102 through trench etching. The epitaxial layer 102 may include a plurality of first trenches 105, which are distributed at intervals based on device performance requirements. The substrate further includes a first oxide layer 103 conformally covering at least part of the surface of the epitaxial layer 102 and the inner wall of the first trench 105. Optionally, the constituent material of the first oxide layer 103 may be silicon oxide, or other materials capable of serving as the field oxide layer 107 of the gate.

In a possible implementation manner, S11 may include S111-S113.
S111: providing an initial substrate;
S112: performing trench etching on the epitaxial layer 102 to form the first trench 105;
S113: depositing an oxide film to form a first oxide layer 103 conformally covering at least part of the surface of the epitaxial layer 102 and the inner wall of the first trench 105.

Specifically, referring to FIG. 3, the initial substrate includes the substrate layer 101 and the epitaxial layer 102 located on one side of the substrate layer 101. Trench etching may be wet etching or dry etching using a mask. Preferably, a dry etching method is adopted; more preferably, an isotropic dry etching method is used to form the first trench 105 with high dimensional accuracy and a smooth inner wall, thereby improving the smoothness of the first oxide layer 103.

Optionally, the oxide film deposition in S113 is the deposition process of a first thin layer of the field oxide layer 107, which can be achieved by methods such as thermal oxidation, CVD, PVD, ALD, etc. Taking the formation of a silicon dioxide layer by thermal oxidation as an example: first deposit polysilicon material in the epitaxial layer 102 and the first trench 105, then perform thermal oxidation treatment to obtain the first oxide layer 103. The thermal oxidation treatment may be dry oxygen or wet oxygen heat treatment, preferably wet oxygen heat treatment. Taking the deposition method as an example: an oxide material may be deposited on the surfaces of the epitaxial layer 102 and the first trench 105 to form the first oxide layer 103, as shown in FIG. 4.

By forming the conformal first oxide layer 103, it can serve as a subsequent field oxide structure and an isolation layer during the preparation of the second oxide layer 104, avoiding ion out-diffusion of the epitaxial layer and structural damage during the preparation of the second oxide layer 104.

S12: forming a polysilicon structure 201 that fills the first trench 105; along direction L from the bottom to the top of the first trench 105, the doping concentration of the polysilicon structure 201 decreases progressively.

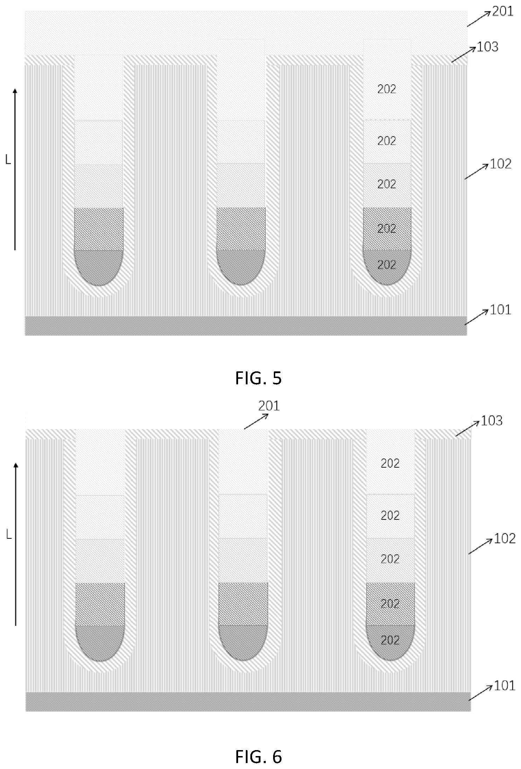

Specifically, referring to FIGS. 5-6, the polysilicon structure 201 is formed on the first oxide layer 103 within the first trench 105 and fills the first trench 105, wherein the polysilicon structure 201 may be formed through polysilicon deposition.

Optionally, the ion doping type of the polysilicon structure 201 may be N-type doping or P-type doping, which may be selected based on functional requirements of the device. Exemplarily, the dopant elements may include, but are not limited to, one or more of boron (B), aluminum (Al), gallium (Ga), indium (In), phosphorus (P), arsenic (As), antimony (Sb), bismuth (Bi), or other elements capable of achieving P-type doping or N-type doping. In some embodiments, P-type doping is adopted, and the dopant elements may be boron (B), aluminum (Al), gallium (Ga), indium (In), etc. In other embodiments, a base isolation layer 110 is doped with N-type, and the dopant elements may be phosphorus (P), arsenic (As), antimony (Sb), bismuth (Bi), etc.

In a possible implementation, along the depth direction of the first trench 105, the doping concentration of the polysilicon structure 201 decreases in a stepped manner or a gradual manner from the bottom to the top of the trench; preferably, the gradual decrease may be a linear decrease, where the doping concentration refers to the concentration of dopant elements in the polysilicon structure 201. Optionally, the polysilicon structure 201 may be formed by CVD, PVD, ALD, or other methods.

In some embodiments, the polysilicon structure 201 may be formed through two or more deposition processes and corresponding etch-back processes; the polysilicon structure 201 includes multiple polysilicon layers 202 stacked sequentially along the depth direction of the first trench 105, where each deposition process and etch-back process forms one polysilicon layer 202, and the doping concentration of each polysilicon layer 202 changes progressively. Correspondingly, S12 may include: repeatedly performing a process sequence of doped polysilicon deposition and polysilicon etch-back in the first trench 105 to form the multiple polysilicon layers 202. Doped polysilicon deposition refers to achieving in-situ doping by introducing dopant element gas during the polysilicon deposition process.

Specifically, a first structure filling the first trench 105 is formed through doped polysilicon deposition, and then an etch-back process is performed until the remaining thickness of the first structure in the first trench 105 reaches its required thickness, thereby obtaining a first polysilicon layer 202; the doped polysilicon deposition process is conducted again to form a second structure filling the remaining part of the first trench 105, and another etch-back process is performed until the remaining thickness of the second structure reaches its required thickness, thereby obtaining a second polysilicon layer 202; this process is repeated sequentially to obtain the polysilicon structure 201. In this way, through multiple cycles of doped polysilicon deposition and etch-back, polysilicon with a longitudinally stepped or graded doping concentration in the trench can be formed.

Specifically, in chronological order, the gas flow rate of the dopant element gas used in each doped polysilicon deposition step decreases progressively; the dopant element gas can be determined based on the type requirement of the dopant element, and no specific limitation is imposed herein. Exemplarily, the dopant element gas used for P-element doping may be PH₃ or the like. Exemplarily, referring to FIGs. 5 and 6, the polysilicon structure 201 includes five polysilicon layers 202, whose doping concentration increases in a stepped manner from the top to the bottom. The doping concentration of the deposited polysilicon is positively correlated with the corresponding gas flow rate. After oxidation, the thickness of the formed oxide layer changes proportionally, and the step width also changes accordingly. The thickness of each polysilicon layer 202 can be controlled by adjusting the etch-back depth, specifically via regulating the etching time.

In some cases, the flow rate of the dopant element gas remains stable during the deposition of a single polysilicon layer 202, and the gas flow rate of the dopant element gas used for a subsequent polysilicon layer 202 (in chronological order) is lower than that of the previous polysilicon layer 202, so as to achieve a stepped decrease in doping concentration. In other cases, besides the flow rate of the dopant element gas for a subsequent polysilicon layer 202 (in chronological order) being lower than that of the previous one, the flow rate of the dopant element gas also decreases chronologically during the deposition of a single polysilicon layer 202, so as to achieve a gradual decrease in doping concentration.

In this way, by repeatedly performing N cycles (where N is a positive integer greater than or equal to 2) of polysilicon deposition with variable-concentration doping and etch-back, polysilicon with (N-1)-level stepped concentrations is formed. Moreover, by adjusting the flow rate of the dopant element gas during the polysilicon deposition process and the etch-back depth, in-situ doping can be achieved while regulating the step width and depth, thereby facilitating the subsequent control of the step thickness and depth of the second oxide layer 104.

Optionally, the etch-back process adopts dry etching, preferably isotropic dry etching, so that the trench formed after etch-back has precise dimensions and a smooth inner wall, which is conducive to the precise control of the dimension and shape of the subsequent polysilicon layer 202. Process conditions such as the etching rate of the etch-back can be set based on actual requirements, and no limitation is imposed herein. The etch-back method used has etching inertness to the first oxide layer 103.

In a possible implementation manner, the variation degree of the doping concentration of the polysilicon structure 201 is determined based on simulated structural design data corresponding to the shielded-gate-trench device, where the simulated structural design data includes at least parameters such as the dimensions of the epitaxial layer 102, body region 106, second trench 204, field oxide layer 107, and shielded gate structure 205 in the shielded-gate-trench device. In the case where the polysilicon includes multiple polysilicon layers 202, the doping concentration and thickness of each polysilicon layer 202 are determined based on the simulated structural design data corresponding to the shielded-gate-trench device. The simulated structural design data is generated based on a pre-defined electric field distribution in the body region 106 of the shielded-gate device; the body region 106 includes a part of the epitaxial layer 102, the field oxide layer 107 located in the epitaxial layer 102, and the shielded gate structure 205. A lateral electric field is introduced into the body region 106 of the device by arranging the shielded gate structure 205 and the field oxide layer 107, which can assist in depleting the drift region and improve the voltage resistance performance of the device. The lateral electric field in the body region 106 has a certain field strength distribution along the longitudinal direction, and the pre-defined electric field distribution is used to indicate the desired strength distribution of the lateral electric field in the body region along the depth direction of the first trench 105. In the pre-defined electric field distribution, the field strength in the middle part of the body region 106 tends to be close to that at both ends. The doping concentration and thickness of different polysilicon layers 202 are designed by back-calculating from the desired field strength distribution, so that the lateral field strength distribution in the device body region 106 is uniform and the field strength integral area (indicating voltage resistance performance) tends to be maximized, which significantly avoids problems such as insufficient voltage resistance caused by low field strength in the middle part of existing structures (e.g., FIG. 1).

S13: etching back the polysilicon structure 201 to form a second trench 204.

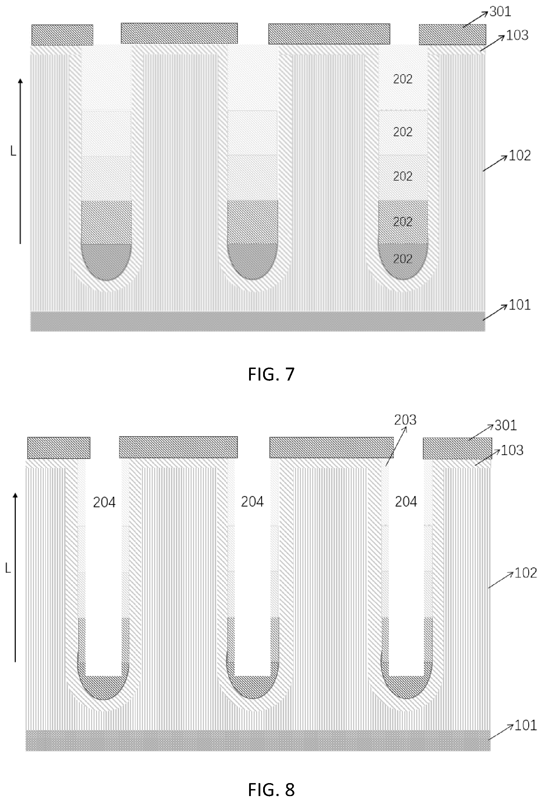

Specifically, here a deep trench is formed by performing an overall etch-back on the polysilicon structure 201, and the etch-back method is preferably anisotropic dry etching. Referring to FIG. 8, the polysilicon trench wall of the second trench 204 overlaps the first oxide layer 103 on the inner wall of the first trench 105, and the second trench 204 is used to form the shielded gate structure 205. It is understandable that the variation in the doping concentration of the polysilicon trench wall is formed based on the variation in the doping concentration of the polysilicon structure 201; the higher the doping concentration, the thicker the oxide layer formed after the polysilicon is oxidized, and correspondingly, the width of the second trench 204 becomes smaller, and the width of the corresponding region of the shielded gate structure 205 also becomes smaller.

In a possible implementation manner, S13 may include S131-S133:
S131: grinding the polysilicon structure 201 until the first oxide layer 103 on top surfaces of the epitaxial layer 102 is exposed;
S132: forming a mask layer 301 on the first oxide layer 103 and the polysilicon structure 201 to mask the first oxide layer 103 and a first portion of the polysilicon structure 201 configured to be a sidewall of the polysilicon trench wall of the second trench 204, while exposing a second portion of the polysilicon structure 201 that defines the second trench 204;
S133: dry etching the substrate with the mask layer 301 to form the second trench 204, and removing the mask layer 301.

Specifically, after the polysilicon structure 201 is formed by deposition, there is a portion of excess polysilicon material covering the first oxide layer 103 on the epitaxial layer 102, as shown in FIG. 5. The surface layer portion of the polysilicon structure 201 is removed by means of chemical mechanical polishing (CMP) or the like until the first oxide layer 103 is exposed. After polishing, the surface of the polysilicon structure 201 is preferably flush with the first oxide layer 103 on the epitaxial layer 102, as shown in FIG. 6.

Further, referring to FIG. 7, the mask layer 301 may be formed through a photolithography patterning process, and specifically may be formed by CVD, such as plasma enhanced CVD (PECVD), high density plasma CVD (HDPCVD), sub atmospheric CVD (SACVD), low pressure CVD (LPCVD), ALD, plasma enhanced ALD (PEALD), or other types of CVD processes. The material of the mask layer 301 may include one or more of silicon nitride, titanium nitride, silicon dioxide. Referring to FIGS. 7 and 8, the mask layer 301 is used to expose a polysilicon region corresponding to the subsequently formed second trench 204, so as to facilitate deep trench etching and thereby obtain the second trench 204.

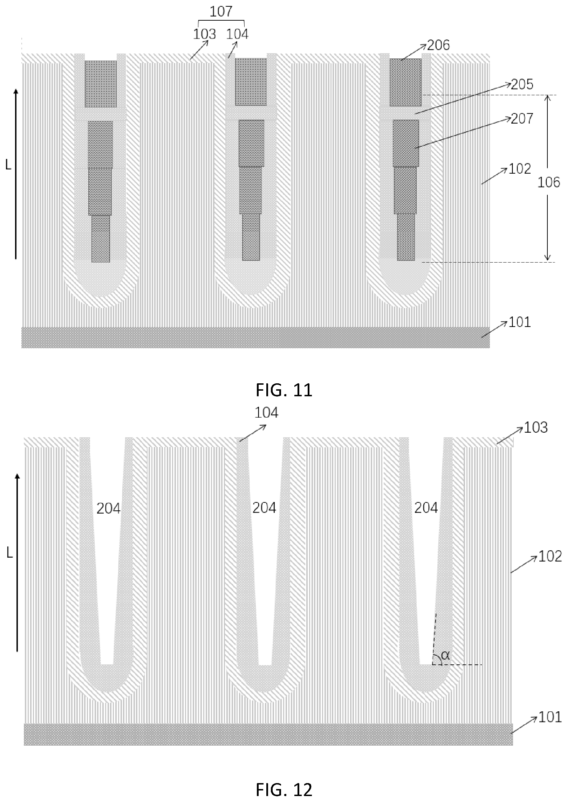

In a possible implementation manner, the sidewall inclination angle and bottom depth of the second trench 204 can be adjusted according to requirements to regulate the sidewall gradient variation and bottom thickness of the second oxide layer 104. Correspondingly, the process parameters for the etching process are determined based on the preset etch angle corresponding to the simulated structural design data and a preset thickness of a bottom wall of the trench wall of the second trench. The thickness of the bottom wall of the second trench refers to the distance between the bottom inner surface of the second trench and the bottom inner surface of the first oxide layer (which is away from the epitaxial layer). The preset etch angle is inversely correlated with a thickness gradient of the second oxide layer 104. The preset etch angle α refers to the acute angle between a sidewall of the second trench 204 and a top surface of the substrate 101, and it is the complement of the acute angle between the sidewall of the second trench and the bottom inner surface of the second trench. Specifically, the smaller the preset etch angle α, the more inclined the sidewall of the second trench 204 becomes, the narrower the width of its bottom inner surface, and the larger the thickness variation gradient of the sidewall of the second oxide layer 104. In a reference example, referring to FIG. 12, the polysilicon structure 201 is filled with a uniform doping concentration. By adjusting the preset etch angle α, an inclined sidewall of the second trench is formed. Along the direction L from the bottom to the top of the second trench 204, the thickness of the second oxide layer 104 decreases gradually, while the width of the shielded gate structure 205 increases gradually. Specifically, the process parameters for the etching process may include, but are not limited to, the ratio of mixed etching gases, radio frequency (RF) parameters, and the like-such as the ratio of fluorocarbon gas to oxygen. The etching process parameters are set based on the preset etch angle and the preset thickness of the bottom wall to achieve a specific sidewall inclination angle, thereby enabling free regulation of the thickness variation and bottom thickness of the polysilicon sidewall 203.

S14: forming a second oxide layer 104 on the polysilicon trench wall of the second trench 204 through oxidation, wherein along direction L from the bottom to the top of the first trench 105, the thickness of the second oxide layer 104 decreases progressively.

In this way, by utilizing the positive correlation between the polysilicon doping concentration and the thickness of the formed oxide film, polysilicon with longitudinally multi-level stepped or graded doping concentration is formed in the trench. Subsequently, secondary trench etching and wet oxygen oxidation are performed to form, in one step, multi-level stepped field oxides with freely adjustable width and depth, or field oxides with graded thickness.

Optionally, the oxidation treatment of the polysilicon trench wall may be a dry oxygen thermal oxidation process or a wet oxygen thermal oxidation process. In a preferred implementation manner, the oxidation treatment of the polysilicon trench wall of the second trench 204 adopts a wet oxygen thermal oxidation process, so that the difference in the thickness of the oxide layers formed by polysilicon with different doping concentrations is more significant, thereby enhancing the distribution modulation effect of the lateral electric field in the body region. After the oxidation of the polysilicon trench wall is completed, a field oxide layer 107 with graded or stepped thickness is formed.

It is understandable that the thickness of the second oxide layer 104 changes correspondingly with the variation in the doping concentration of the polysilicon sidewall 203. In some implementations, along the direction from the bottom to the top of the first trench 105, the doping concentration of the polysilicon structure 201 decreases in a stepped manner, and the thickness of the second oxide layer 104 also decreases in a stepped manner. In other implementations, along the direction from the bottom to the top of the first trench 105, the doping concentration of the polysilicon structure 201 decreases in a gradual manner, and the thickness of the second oxide layer 104 also decreases in a gradual manner.

In summary, in the present disclosure, a filled polysilicon structure 201 is formed in the first trench 105 of the epitaxial layer 102. Along the direction from the bottom to the top of the first trench 105, the doping concentration of the polysilicon structure 201 decreases progressively, forming a pre-structure for field oxide formation. Subsequently, an etch-back process is performed on the polysilicon structure 201 to form a second trench 204, thereby obtaining a trench inner wall with a concentration variation. Further, an oxidation process is carried out to oxidize the polysilicon inner wall, resulting in the formation of a second oxide layer 104. Due to the variation in doping concentration, the thickness of the second oxide layer 104 also changes accordingly. The second oxide layer 104 then combines with the first oxide layer 103 to form a field oxide layer 107 whose thickness changes progressively from the bottom to the top of the trench. This enables free regulation of the width of the shielded gate structure 205 in the second trench 204, significantly addressing the issue of low electric field strength in the middle of the body region 106. As a result, the integral area of the electric field in the body region 106 tends to be maximized, effectively improving the voltage resistance performance of the device. Furthermore, during the preparation of the second oxide layer, only a single thermal oxidation process is required. This results in a low thermal budget and prevents the reverse diffusion of doped impurities in the substrate, thereby avoiding a reduction in the device's breakdown voltage performance. In addition, by modulating the doping concentration of the polysilicon structure 201 within the trench, free regulation of the thickness dimension and thickness variation of the field oxide layer 107 can be achieved. This approach does not impose restrictions on the thickness of the field oxide layer, offering a high degree of freedom in structure preparation and enabling adaptation to voltage-resistant devices with various voltage requirements.

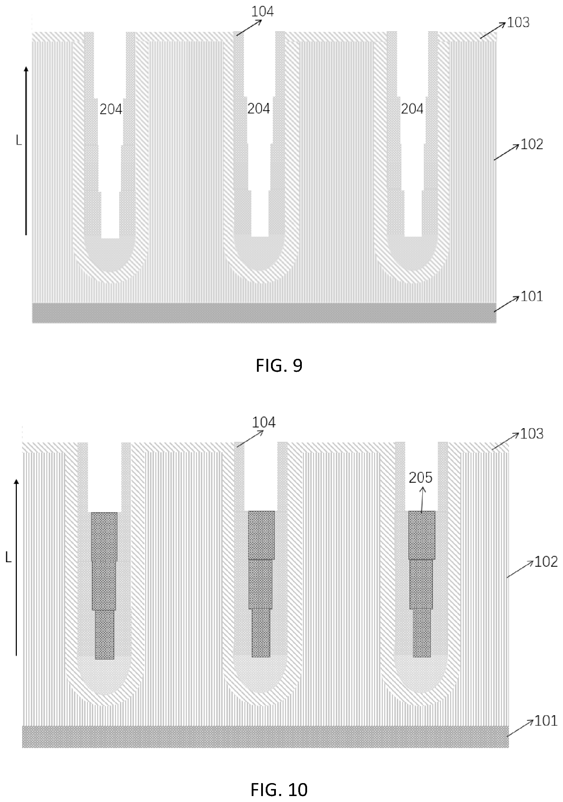

Based on some or all of the above embodiments, in a possible implementation, referring to FIG. 10, after S14, the method further includes S15: forming a shielded gate structure 205 conformally adhering to the second oxide layer 104 in the second trench 204, wherein along the direction L from the bottom to the top of the second trench 204, the width of the shielded gate structure 205 increases progressively, so as to achieve uniform distribution of the electric field and improve the voltage resistance performance.

In some implementations, referring to FIGs. 9 and 10, along the direction L from the bottom to the top of the second trench 204, the thickness of the second oxide layer 104 decreases in a stepped manner, while the width of the shielded gate structure 205 increases in a stepped manner.

In a possible implementation manner, the shielded gate structure 205 partially fills the second trench 204. In addition to the above-mentioned process steps, the preparation of the shielded-gate-trench device also includes processes such as gate formation, body region 106 doping, source doping, and contact hole formation. For example, the formation of the gate structure 206 can be specifically realized by continuously forming an isolation oxide layer 207 on top of the shielded gate structure 205 as shown in FIG. 11, wherein the isolation oxide layer 207 is used to isolate the gate from the shielded gate. Further, a gate structure 206 is formed on the isolation oxide layer 207, and a gate dielectric layer can also cover the epitaxial layer 102 and the surface of the first trench 105 to form contact holes. Materials of the gate and the shielded gate may be polysilicon, etc. In other embodiments, the materials of the gate and the shielded gate can also be metal gate materials such as copper, aluminum, tungsten, chromium, titanium, silver, platinum, nickel, or gold. The above gate formation process is only an exemplary solution.

In related technologies, for the preparation process of the field oxide layer 107, polysilicon material can also be filled in the trench first, and then the mask layer 301 is used to perform multiple trench etching operations with different widths, and sidewall thermal oxidation is conducted after each etching to prepare a stepped field plate. However, this method has difficulties in ensuring trench size and precision, and requires high thermal budget. Moreover, the doping concentration of the base layer 101 is higher than that of the epitaxial layer 102. Multiple thermal oxidation treatments cause ions in the base layer 101 to diffuse reversely into the epitaxial layer 102, resulting in an increase in the doping concentration of the epitaxial layer 102. The reverse diffusion problem is prominent, which seriously affects the voltage resistance performance of the device. Alternatively, a composite field oxide structure can be adopted to form a stepped field plate through the difference in etching rate. Specifically, a composite oxide layer made of two or more materials is formed on the inner wall of the trench. Differences in density and material properties of different material layers lead to variations in the etching rate of the oxide layer (e.g., hydrofluoric acid etching rate), and the remaining parts of various materials form the stepped field oxide. However, the field oxide layer 107 prepared by this method is too thick, which is only suitable for devices with high-voltage thick field plates. When a thinner field oxide layer 107 is required, it is difficult to form steps during the etching process, and there are significant restrictions on material selection.

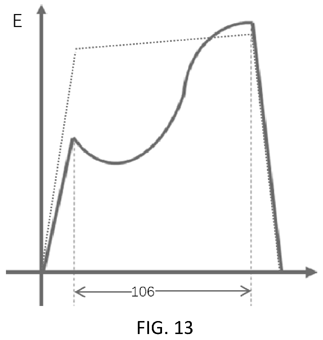

In contrast, the presently disclosed solution forms a polysilicon structure 201 with a progressively changing doping concentration in the first trench 105, and performs etch-back to form the corresponding polysilicon trench wall. Based on the characteristic that a higher polysilicon doping concentration leads to a thicker oxide layer, a field oxide layer 107 with a progressively changing longitudinal thickness is formed. During this process, only one thermal oxidation step is required, resulting in a low thermal budget. Furthermore, according to the requirements of the simulated design structure, multi-layer field oxide steps with desired depth and width combinations can be realized by adjusting the doping concentration and etching depth. This solution offers high flexibility in structure preparation, is suitable for the preparation of field oxides with various thicknesses, and thus can meet the process development needs of low, medium, and high-voltage SGT devices. Compared with the device structure shown in FIG. 1, in the shielded-gate-trench device formed by adopting the technical solution of the present disclosure, the electric field distribution in the device body region 106 is significantly improved. Referring to FIG. 13, the curve *I* in the figure represents the body region electric field distribution of the device structure in FIG. 1, and the dashed line *II* represents the simulated body region electric field distribution based on the device structure in FIG. 11. It can be seen that the latter body region electric field distribution is uniform, and the electric field integral area tends to be maximized, which effectively avoids the device voltage resistance defect caused by excessively low electric field strength in the middle part.

The shielded-gate-trench device of the present disclosure is described below with reference to FIG. 11. It is understandable that the shielded-gate-trench device in FIG. 11 is a technical solution of a specific embodiment of the present disclosure. The shielded-gate-trench device of the present disclosure may include fewer or more structural features, and is not limited to the device structure described in FIG.11.

The shielded-gate-trench device includes a substrate, a first oxide layer 103, and a field oxide layer 107. The substrate includes an epitaxial layer 102 and a first trench 105 located in the epitaxial layer 102. The first oxide layer 103 covers at least part of the epitaxial layer 102 and an inner wall of the first trench. The field oxide layer 107 is disposed on the inner wall of the first trench, and the field oxide layer 107 encloses to form a second trench 204; along the direction from the bottom to the top of the first trench 105, the thickness of the field oxide layer 107 decreases progressively.

In a possible implementation, along the direction from the bottom to the top of the first trench 105, the thickness of the field oxide layer 107 decreases in a stepped manner; alternatively, along the direction from the bottom to the top of the first trench 105, the thickness of the field oxide layer 107 decreases in a gradual manner.

In a possible implementation, the shielded-gate-trench device further includes a shielded gate structure 205 formed in the second trench 204. The shielded gate structure 205 conformally and partially fills the second trench 204, and along the direction from the bottom to the top of the second trench 204, the width of the shielded gate structure 205 increases progressively.

In a possible implementation, along the direction from the bottom to the top of the second trench 204, the width of the shielded gate structure 205 increases in a stepped manner; alternatively, along the direction from the bottom to the top of the second trench 204, the width of the shielded gate structure 205 increases in a gradual manner.

In a possible implementation manner, the shielded-gate-trench device further includes an isolation oxide layer 207 and a gate structure 206 that are located in the second trench 204 and stacked above the shielded gate structure 205, wherein the isolation oxide layer 207 is disposed between the shielded gate structure 205 and the gate structure 206.

It should be noted that the above embodiments of the shielded-gate-trench device and the method for preparing the same are based on the same application concept, and the shielded-gate-trench device can be prepared by using the above-mentioned method for preparing the shielded-gate-trench device.

Embodiments of the present disclosure further provide an electronic device, which includes the above-mentioned shielded-gate-trench device. Specifically, the electronic device includes the shielded-gate-trench device and electronic components connected to the shielded-gate-trench device.

The electronic device may be any electronic product or device such as a mobile phone, a Personal Digital Assistant (PDA), a tablet computer (pad), a notebook computer, a game console, a television, a Video Compact Disc (VCD), a Digital Video Disc (DVD), a navigator, a camera, a video camera, a voice recorder, an MP3 player, an MP4 player, a PlayStation Portable (PSP), etc. It may also be any intermediate product that includes electronic devices fabricated using the above-mentioned shielded-gate-trench device.

It should be noted that: the sequence of the above embodiments of the present disclosure is only for descriptive purposes and does not indicate the superiority or inferiority of the embodiments. In addition, the above description has been made for specific embodiments of this specification. Other embodiments fall within the scope of the appended claims. In some cases, the actions or steps described in the claims may be performed in an order different from that in the embodiments while still achieving the desired results. Furthermore, the processes depicted in the drawings do not necessarily require the specific order or sequential order shown to achieve the desired results. In certain implementations, multitasking and parallel processing are also possible or may be advantageous.

The various embodiments in this specification are described in a progressive manner. For the same or similar parts between the various embodiments, reference may be made to each other. Each embodiment focuses on the differences from other embodiments. In particular, as for the device embodiments, since they are basically similar to the method embodiments, the description is relatively concise, and for relevant parts, reference may be made to the relevant descriptions of the method embodiments.

A person of ordinary skill in the art can understand that all or part of the steps for implementing the above embodiments can be completed by hardware, or by a program instructing relevant hardware to complete. The program may be stored in a computer-readable storage medium. The aforementioned storage medium may be a read-only memory (ROM), a magnetic disk, an optical disk, etc.

The above descriptions are only preferred embodiments of the present disclosure and are not intended to limit the present disclosure. Any modification, equivalent replacement, improvement, etc. made within the spirit and principles of the present disclosure shall be included in the scope of the present disclosure.

## Claims

1. A method for preparing a shielded-gate-trench device, comprising:
providing a substrate, wherein the substrate comprises an epitaxial layer, a first trench within the epitaxial layer, and a first oxide layer covering an inner wall of the first trench and at least partially covering the epitaxial layer;
forming a polysilicon structure filling the first trench, wherein a doping concentration of the polysilicon structure decreases progressively along a direction from a bottom to a top of the first trench;
etching back the polysilicon structure to form a second trench, wherein a polysilicon trench wall of the second trench overlaps the first oxide layer on the inner wall of the first trench, and the second trench is used to form a shielded gate structure; and
forming a second oxide layer on the polysilicon trench wall of the second trench through oxidation, wherein a thickness of the second oxide layer decreases progressively along the direction from the bottom to the top of the first trench.

2. The method according to claim 1, wherein along the direction from the bottom to the top of the first trench, the doping concentration of the polysilicon structure decreases in a stepped manner, and the thickness of the second oxide layer decreases in a stepped manner; or
along the direction from the bottom to the top of the first trench, the doping concentration of the polysilicon structure gradually decreases, and the thickness of the second oxide layer gradually decreases.

3. The method according to claim 1, wherein the polysilicon structure comprises multiple polysilicon layers stacked along a depth direction of the first trench, and doping concentrations of the multiple polysilicon layers exhibit a progressive gradation; wherein forming the polysilicon structure filling the first trench comprises:
repeatedly performing a process sequence of doped polysilicon deposition and polysilicon etch-back to form the multiple polysilicon layers, wherein a gas flow rate of dopant elements is progressively decreased with each deposition.

4. The method according to claim 3, wherein a doping concentration and thickness of each of the multiple polysilicon layers are determined based on simulated structural design data corresponding to the shielded-gate-trench device ,wherein the simulated structural design data is generated based on a pre-defined electric field distribution in a body region of the shielded-gate-trench device, wherein the pre-defined electric field distribution is used to indicate a desired strength distribution of a lateral electric field in the body region along the depth direction of the first trench.

5. The method according to claim 1, wherein the oxidation of the polysilicon trench wall of the second trench is performed by a wet oxygen thermal oxidation process.

6. The method according to any one of claims 1-5, wherein providing the substrate comprises:
providing an initial substrate, wherein the initial substrate comprises a substrate layer and an epitaxial layer on one side of the substrate layer;
etching the epitaxial layer to form the first trench; and
forming the first oxide layer by depositing an oxide film, wherein the first oxide layer conformally covers at least a part of the epitaxial layer and the inner wall of the first trench.

7. The method according to any one of claims 1-5, wherein etching back the polysilicon structure to form the second trench comprises:
grinding the polysilicon structure until the first oxide layer on top surfaces of the epitaxial layer is exposed;
forming a mask layer on the first oxide layer and the polysilicon structure to mask the first oxide layer and a first portion of the polysilicon structure configured to be a sidewall of the polysilicon trench wall of the second trench, while exposing a second portion of the polysilicon structure that defines the second trench;
dry etching the substrate with the mask layer to form the second trench, and removing the mask layer.

8. The method according to claim 7, wherein process parameters for the dry etching are determined based on a preset etch angle corresponding to simulation structural design data and a preset thickness of a bottom wall of the polysilicon trench wall of the second trench, wherein the preset etch angle is inversely correlated with a thickness gradient of the second oxide layer, wherein the preset etch angle is defined as an acute angle between a sidewall of the second trench and a top surface of the substrate, and is the complement of an acute angle between the sidewall of the second trench and a bottom wall of the second trench.

9. The method according to any one of claims 1-5, wherein after forming the second oxide layer on the polysilicon trench wall of the second trench through oxidation, the method further comprises:
forming the shielded gate structure in the second trench, wherein the shielded gate structure conforms to a shape of the second oxide layer, wherein along a direction from a bottom to a top of the second trench, a width of the shielded gate structure increases progressively.

10. A shielded-gate-trench device, wherein the shielded-gate-trench device is prepared based on the method according to any one of claims 1-9.

11. The shielded-gate-trench device according to claim 10, comprising:
a substrate, comprising an epitaxial layer and a first trench located in the epitaxial layer;
a first oxide layer covering an inner wall of the first trench and at least partially covering the epitaxial layer; and
a field oxide layer disposed on the inner wall of the first trench, wherein the field oxide layer encloses to form a second trench, and a thickness of the field oxide layer decreases progressively along a direction from a bottom to a top of the first trench.
